# EUROPEAN PATENT SPECIFICATION

(11) **EP 1 612 902 B1**
(45) Date of publication and mention of the grant of the patent: **07.11.2007**
(21) Application number: 05013941.9
(22) Date of filing: 28.06.2005
(51) Int. Cl.: H02G 3/08, H02G 3/14

(54) **Waterproof case of electronic apparatus**
Wasserdichtes Gehäuse eines elektronischen Gerätes
Boîtier étanche à l'eau d'un dispositif électronique

(30) Priority: 02.07.2004 JP 2004196985
(43) Date of publication of application: 04.01.2006
(73) Proprietor: ALPS ELECTRIC CO., LTD., Tokyo 145-8501 (JP)
(72) Inventor: Matsuzaki, Satoru, Ota-ku Tokyo 145-8501 (JP)
(74) Representative: Klunker . Schmitt-Nilson . Hirsch

(56) References cited:
- EP-A- 1 128 462
- EP-A- 1 369 953
- PATENT ABSTRACTS OF JAPAN vol. 1997, no. 03, 31 March 1997 (1997-03-31) & JP 08 306221 A (ICHIKOH IND LTD), 22 November 1996 (1996-11-22)
- PATENT ABSTRACTS OF JAPAN vol. 2003, no. 12, 5 December 2003 (2003-12-05) & JP 2004 048418 A (ALPS ELECTRIC CO LTD), 12 February 2004 (2004-02-12)

## Description

### BACKGROUND OF THE INVENTION

### 1. Field of the Invention

The present invention relates to a waterproof case according to the preamble of claim 1.

### 2. Description of the Related Art

An outer case of an outdoor electronic apparatus such as a converter for receiving a satellite broadcast needs to be a waterproof case whose inner space for accommodating the electronic apparatus has high hermetic properties (for example, see Japanese Unexamined Patent Application Publication No. 2001-244658). Fig. 3 is an explanatory view showing a conventional example of such a type of waterproof case. In such a prior waterproof case, opening ends of a first case member 1 and a second case member 2 composed of a resin molded product are connected to be snap-fitted by using an adhesive in combination. A converter (not shown) for receiving a satellite broadcast is accommodated in an inner space 'S' of the waterproof case, which is defined by being covered by both the case members 1 and 2.

A cylindrical inner wall part 5 having engaging holes 4 at a plurality of places peripherally, an outer wall part 6 surrounding the inner wall part 5, a ring-shaped recess 7 which is formed between the inner wall part 5 and the outer wall part 6 are formed at the opening end of the first case member. A proper amount of adhesive 3 is filled into the inside of the ring-shaped recess 7 in advance through the entire periphery thereof. On the other hand, a cylindrical elastic wall 8 which is fitted around the inner wall part 5 of the first case member 1 and is disposed inside the ring-shaped recess 7, and protrusions 9 which protrude from a plurality of places peripherally of an inner peripheral surface of the cylindrical elastic wall 8 to be snap-fitted into the engaging holes 4 of the first case member 1 are formed at the opening end of the second case member 2.

When the first and the second case members 1 and 2 are connected to each other, a predetermined amount of adhesive is filled into the inside of the ring-shaped recess 7, and then the cylindrical elastic wall 8 is fitted around the inner wall part 5 from an upper direction in the figure, such that each of the protrusions 9 is snap-fitted into the corresponding engaging hole 4. At this time, first, a slant face 9a of the protrusion 9 abuts a remained portion 5a existed between the front end of the inner wall part 5 and the engaging hole 4. Therefore, along the insertion of the cylindrical elastic wall 8 into the ring-shaped recess 7, the remained portion 5a is slowly pressed toward the inner direction by the slant face 9a, and the protrusion 9 is snap-fitted into the engaging hole 4 when the protrusion 9 goes over the remained portion 5a. Further, when each of the protrusion 9 is snap-fitted into the corresponding engaging hole 4, the leading end portion of the cylindrical elastic wall 8 is buried in the adhesive 3 within the inside of the ring-shaped recess 7. When the adhesive is cured, the first and second case members 1 and 2 are strongly fixed to each other. The communicating passage between the inner space 'S' and the outside, which can be made inside the ring-shaped recess, is sealed by the adhesive 3, whereby the hermetic properties can be improved.

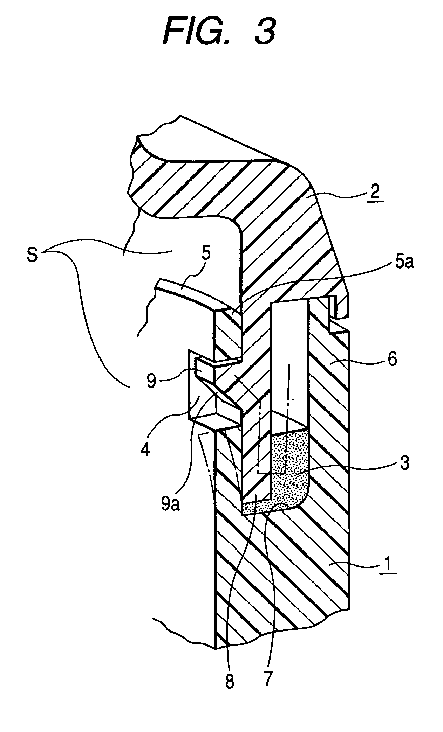

However, in the conventional waterproof case shown in Fig. 3, when the protrusion 9 of the second case member 2 is snap-fitted into the engaging hole 4 of the first case member 1, the remained portion 5a is strongly pressed against the protrusion 9 just before the snap-fitting is finished. Therefore, as shown with a one-dotted chain line in the drawing, the inner wall part 5 of the first case member 1 is bent toward the inside, and the elastic wall 8 of the second case member 2 is bent toward the outside. As a result, a gap is formed between the inner wall part 5 and the cylindrical elastic wall 8, and the uncured adhesive 3 to which the bent cylindrical elastic wall 8 applies pressure is likely to flow into the gap. Therefore, the adhesive 3, which reaches the engaging hole 4, flows into the inner space 'S' and causes damage to the reliability of the electronic apparatus.

Further, the above-described conventional waterproof case is constructed such that the leading end position of the inner wall part 5 is flushed with the leading end position of the outer wall parts 6 along the axial direction of the first case member 1. Therefore, the structure of a metal mold for forming the engaging hole 4 becomes complicated, and there is a problem in that it is not possible to manufacture the conventional waterproof case at low cost.

In accordance with the preamble of claim 1, EP-A-1 369 953 discloses a waterproof case in which the thin walled portion is fitted around the inner wall part to be inserted into the ring-shaped recess in such a manner that there is a gap between the thin walled portion and also the thick walled portion on the one hand and the outer surface of the inner wall part on the other hand. Due to this gap, adhesive flows into that gap when the first case member and the second case member are connected to each other.

### SUMMARY OF THE INVENTION

The invention has been finalized in view of the inherent drawbacks in the conventional technology, and it is an advantage of the invention that it provides a waterproof case of an electronic apparatus which can be manufactured at a low cost and assurance that adhesive will not flow into an inner space that accommodates the electronic apparatus.

To accomplish the above-described object, there is provided a waterproof case of an electronic apparatus having the features of claim 1.

In such a constructed waterproof case, since the protrusions of the second case member protrude from the thick walled portion, it is possible that the inner wall part of the first case is mainly bent and the thick walled portion is slightly bent when the protrusion is snap-fitted into the engaging hole, such that the bending of the thin walled portion extending from the leading end of the thick walled portion is largely suppressed. Therefore, even though a gap is formed between the inner wall part and the thin walled part inside the ring-shaped recess, the amount of adhesive forced into the gap due to the bending of the thin walled portion is minimalized. Further, since the first case member is constructed such that the rear end position of the engaging hole along the axial direction is set so as not to be positioned at the rear end side more than the leading end of the outer wall part, the distance from the inner bottom surface of the ring-shaped recess to the engaging hole becomes relatively long. Therefore, since it is possible to largely reduce the possibility of the adhesive forced into the gap to flow into the inner space through the engaging hole, and it is possible to form the engaging hole by a simple slide core, reducing cost of the metal mold becomes realized.

In such a constructed waterproof case, the second case member is constructed such that a distance is set between the protrusions and a leading end of the thick walled portion along an axial direction so that the insertion of the thick walled portion into the ring-shaped recess begins at a state in which a slant face of the protrusion abuts a leading end of the inner wall part, when the second case member is connected to the first case member. Specifically, when the protrusion of the second case member is snap-fitted into the engaging hole of the inner wall part of the first case member, firstly, while the slant face of the protrusion abuts the inner wall part and slides thereon, the remained portion existing between the leading end of the inner wall part and the engaging hole is slowly pressed toward the inner direction, and the snap-fitting is finished when the protrusion goes over the remained portion. Therefore, the repulsive force applied to the protrusion from the remained portion is at the highest just before the snap-fitting is finished. Thus, if the insertion of the thick walled portion into the ring-shaped recess begins at a state in which the thick walled portion is slightly bent because the repulsive force applied is still small, the inserting operation is smoothly performed, and the bending of the thick walled portion can be suppressed by the outer wall part of the first case member as well, at the state in which the repulsive force is at the highest. Therefore, the thin walled portion extending from the leading end of the thick walled portion does not press the adhesive forcefully so as to effectively suppress unwanted overflow of the adhesive.

According to the waterproof case of the invention, when the protrusion provided at the thick walled portion of the other case member is fitted into the engaging hole provided at the inner wall part of the one case member, in which opening ends are connected to each other, the bending of the thin walled portion extending from the thick walled portion or from the leading end thereof is suppressed. Therefore, the adhesive barely overflow into the gap formed in the ring-shaped recess due to the bending of the inner wall part. Further, since a relative positional relation between the outer wall and the engaging hole along the axial line of the one case member is considered, the distance from the inner bottom surface of the ring-shaped recess to the engaging hole is set relatively long. Therefore, even though the adhesive flows into the gap at the time of snap-fitting, the possibility of the adhesive reaching the engaging hole becomes low. Further, since the engaging hole can be formed by a simple slide core, there is no need to make the metal mold complex. Therefore, it is possible to provide a waterproof case of an electronic apparatus without worrying about the adhesive flowing into the inner space which accommodates the electronic apparatus and manufacturing cost can be reduced.

### BRIEF DESCRIPTION OF THE DRAWINGS

Fig. 1 is an exploded perspective view of a waterproof case according to an embodiment of the invention;
Fig. 2 is an explanatory view showing main parts of the waterproof case; and
Fig. 3 is an explanatory view showing a waterproof case according to a conventional example.

### DESCRIPTION OF THE PREFERRED EMBODIMENT

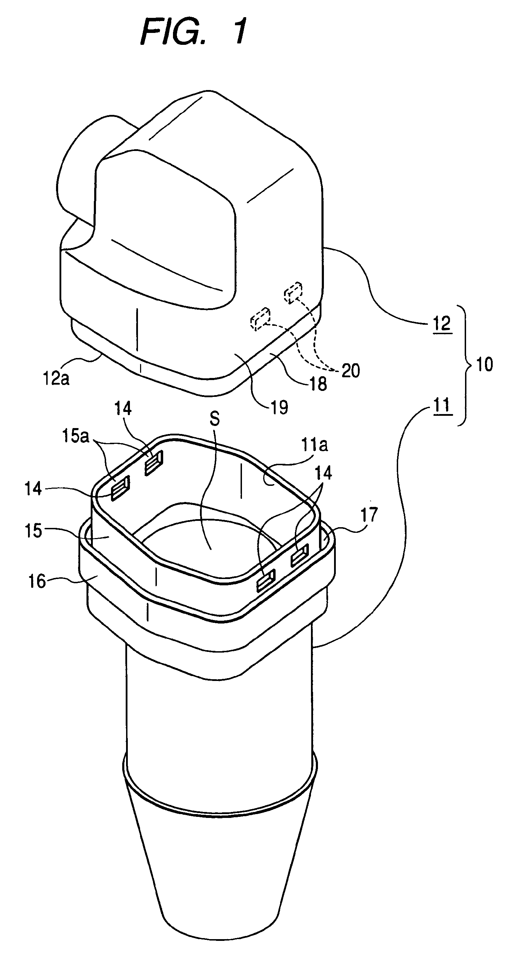

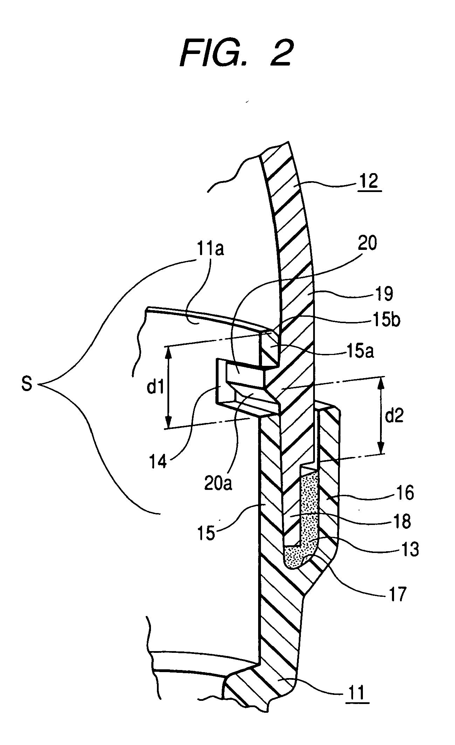

Preferred embodiments of the invention will now be described with reference to the drawings. Fig. 1 is an exploded perspective view of a waterproof case according to an embodiment of the invention, and Fig. 2 is an explanatory view showing main parts of the waterproof case. A waterproof case 10 shown in the drawings is constructed such that opening ends (the vicinity of an opening end 11a and the vicinity of an opening end 12a) of a first case member 11 and a second case member 12 composed of a resin molded product are connected to be snap-fitted by using an adhesive 13 in combination. A converter (not shown) for receiving a satellite broadcast is accommodated in an inner space 'S' of the waterproof case, which is defined by being covered by both the case members 11 and 12.

A cylindrical inner wall part 15 having engaging holes 14 at four places peripherally, an outer wall part 16 surrounding the inner wall part 15, a ring-shaped recess 17 which is formed between the inner wall part 15 and the outer wall part 16 are provided in the vicinity of the opening end 11a of the first case member 11, and a rear end position of the engaging hole 14 is flushed with a leading end position of the outer wall part 16 along the axial direction. Therefore, the inner wall part 15 protrudes more than the outer wall part 16 toward the opening end 11a. Further, a proper amount of adhesive 13 is filled into the inside of the ring-shaped recess 17 in advance along the entire periphery thereof. Further, a remained portion 15a is formed between the leading end of the inner wall part 15 and the engaging hole 14, and a tapered face 15b serving as a guide surface at the time of snap-fitting is formed at an outer peripheral edge of the inner wall part 15 including the remained portion 15a.

On the other hand, a cylindrical thin walled portion 18 which is fitted around the inner wall part 15 of the first case member 11 to be inserted into the ring-shaped recess 17, a cylindrical thick walled portion 19 which is continuously formed to the rear end of the thin walled portion 18 and whose partial portion is inserted into the ring-shaped recess 17, and protrusions 20 which protrude from a four places peripherally of an inner peripheral surface of the thick walled portion 19 to be snap-fitted into the engaging holes 14 are formed in the vicinity of the opening end 12a of the second case member 12. The thickness of the thick walled portion 19 is set to be substantially equal to the width-dimension of the ring-shaped recess 17. Further, a distance d2 between a substantial center of a slant face 20a of the protrusion 20 and a leading end of the thick walled portion 19 (a rear end of the thin walled portion 18) is set so as to be substantially equal to a distance d1 between the tapered face 15b of the first case member 11 and the rear end of the engaging hole 14. Therefore, the second case member 12 is constructed such that the insertion of the thick walled portion 19 into the ring-shaped recess 17 begins at a state in which a slant face 20a of the protrusion 20 abuts a tapered face 15b of the inner wall part 15, when the second case member 12 is connected to the first case member 11.

Further, when the first and second case members 11 and 12 are connected to each other to assemble the waterproof case 10, a predetermined amount of the adhesive 13 is filled into the ring-shaped recess 17, and then the thin walled portion 18 is fitted around the inner wall part 15 to be inserted into the ring-shaped recess 17, such that each of the protrusions 20 is snap-fitted into the corresponding engaging hole 14 at a state in which the leading end portion of the thick walled portion 19 is fitted into the ring-shaped recess 17. During such a process, the slant face 20a of the protrusion 20 abuts the tapered face 15b of the inner wall part 15 just before the insertion of the thin walled portion 18 into the ring-shaped recess 17 is finished, and as the thin part 18 is further inserted into the ring-shaped recess 17, the slant face 20a gradually presses the remained portion 15a toward an inner side while sliding on the tapered face 15b and the insertion of the thick walled portion 19 into the ring-shaped recess 17 begins. When the thick part 19 is gradually inserted into the ring-shaped recess 17, the protrusion 20 goes over the remained portion 15a and enters the inside of engaging hole, whereby the snap-fitting is finished, and most of the thin part 18 is buried in the adhesive 13 in the ring-shaped recess 17, as shown in Fig. 2. Therefore, at this state, when the adhesive 13 is cured, the first and second case members 11 and 12 can be strongly connected, and the communicating passage between the inner space 'S' and outer space, which can be made inside the ring-shaped recess 17, is sealed by the adhesive 3, whereby the hermetic properties can be improved.

According to the embodiment, since the protrusion 20 of the second case member 12 protrudes from the thick walled portion 19, the inner wall part 15 of the first case member 11 is mainly bent and the thick walled portion 19 thereof is slightly bent when the protrusion 20 is snap-fitted into the engaging hole 14. Therefore, the thin walled portion 18 provided continuous to the leading end of the thick walled portion 19. Further, a repulsive force applied to the protrusion 20 from the remained portion 15a is at the highest just before the snap-fitting is finished. However, at this time, the insertion of the thick walled portion 19 into the ring-shaped recess 17 has already started, such that the bending of the thick part 19, to which the repulsive force is applied, is suppressed by the outer wall part 16 of the first case member 11. Therefore, the thick part 18 is barely bent. In the ring-shaped recess 17, a gap is formed between the thin part 18 and the inner wall part 15 which is bent toward the inner side thereof, but the amount of adhesive forced to flow into the gap due to the bending of the thin walled portion 18 is very little. Further, since the first case member 11 is constructed such that the inner wall part 15 protrudes from toward the opening end 11a farther than the outer wall part 16, and a distance from an inner bottom surface of the ring-shaped recess 17 to the engaging hole 14 becomes relatively long. Therefore, even though the adhesive 13 flows into the gap, it is unlikely the adhesive 13 will reach the engaging hole 14. Therefore, the possibility of the adhesive 13 flowing into the inner space 'S' through the engaging hole 14 is largely reduced during the snap-fitting, thus it is unlikely the adhesive 13 will adhere to the converter for receiving the satellite broadcast and cause a deterioration in the reliability thereof.

Further, according to the embodiment, during the snap-fitting, the insertion of the thick part 19 into the ring-shaped recess 17 begins at a state in which the repulsive force applied to the remained portion 15a from the protrusion 20 is still small, so that the inserting operation of the thick part 19 is smoothly performed, whereby the assembly operation is not interfered.

Further, according to the embodiment, since the first case member 11 is constructed such that the rear end position of the engaging hole 14 is flushed with the leading end position of the outer wall part 16 along the axial direction, it is not only that the distance from the inner bottom surface of the ring-shaped recess 17 to the engaging hole 14 can be increased, but also that the engaging hole 14 can be formed by a simple slide core. Therefore, the constitution of the metal mold can be made simple, thereby reducing the manufacturing cost thereof. Further, in the above-described embodiment, it is described with respect to the case in which the invention is applied to the waterproof case of the converter for receiving the satellite broadcast, but the invention is not limited thereto, and of course the invention may be applied to waterproof cases for accommodating electronic apparatus other than the converter.

## Claims

1. A waterproof case of an electronic apparatus, in which an inner space (S) for accommodating the electronic apparatus is defined by connecting a first case member (11) and a second case member (12) composed of a resin molded product to each other:
wherein a cylindrical inner wall part (15) having engaging holes (14) at a plurality of places peripherally, a cylindrical outer wall part (16) surrounding the inner wall part (15), a ring-shaped recess (17) which is formed between the inner wall part (15) and the outer wall part (16), into which a part of the second case member (12) in inserted in a an insertion direction along an axial direction of the second case member (12), and into which an adhesive (13) is filled at least at an inner bottom portion are provided at the opening end of the first case member (11), and a rear end position of the engaging hole (14) along an axial direction as seen in the insertion direction is set flush with or before the position of a leading end of the outer wall part (16); and wherein
a cylindrical thin walled portion (18) which is fitted around the inner wall part (15) to be inserted into the ring-shaped recess (17), a cylindrical thick walled portion (19) having the thickness substantially equal to the width-dimension of the ring-shaped recess (17), which is continuously formed to the rear end of the thin walled portion (18), and whose partial portion is inserted into the ring-shaped recess (17), and protrusions (20), which protrude from a plurality of places peripherally of an inner circumferential surface of the thick walled portion (19) to be snap-fitted into the engaging holes (14) are formed at the opening end of the second case member (12)
**characterized in that** said inner wall past (15) is in contact with said thick valled portion (19).

2. The waterproof case of the electronic apparatus according to Claim 1,
**characterized in that** the second case member (12) is constructed such that a distance is set between the protrusion (20) and a leading end of the thick walled portion (19) along an axial direction so that the insertion of the thick walled portion (19) into the ring-shaped recess (17) begins at a state in which a slant face (20a) of the protrusion (20) abuts a leading end of the inner wall part (15), when the second case member (12) is connected to the first case member (11).

## Patentansprüche

1. Wasserdichtes Gehäuse eines elektronischen Geräts, bei dem ein Innenraum (S) zum Aufnehmen des elektronischen Geräts gebildet ist, indem ein erstes Gehäuseelement (11) und ein zweites Gehäuseelement (12) aus einem Formerzeugnis aus Harzmaterial miteinander verbunden werden;
wobei ein zylindrischer innerer Wandteil (15) mit Eingriffsöffnungen (14) an einer Mehrzahl von peripheren Stellen, ein den inneren Wandteil (15) umgebender zylindrischer äußerer Wandteil (16) und eine ringförmige Vertiefung. (17), die zwischen dem inneren Wandteil (15) und dem äußeren Wandteil (16) gebildet ist und in die ein Teil des zweiten Gehäuseelements (12) in einer Einführrichtung entlang einer Axialrichtung des zweiten Gehäuseelements (12) eingeführt ist und in die ein Klebstoff (13) zumindest an einem inneren Bodenbereich eingefüllt ist, an dem Öffnungsende des ersten Gehäuseelements (11) vorgesehen sind und eine rückwärtige Endposition der Eingriffsöffnung (14) entlang der Axialrichtung bei Betrachtung in der Einführrichtung bündig mit oder vor der Position eines vorderen Endes des äußeren Wandteils (16) angeordnet ist; und
wobei ein zylindrischer dünnwandiger Bereich (18), der zum Einführen in die ringförmige Vertiefung (17) um den inneren Wandteil (15) gepasst ist, ein zylindrischer dickwandiger Bereich (19), dessen Dicke im Wesentlichen gleich der Breitenabmessung der ringförmigen Vertiefung (17) ist und der in kontinuierlicher Weise an dem hinteren Ende des dünnwandigen Bereichs (18) ausgebildet ist und der partiell in die ringförmige Vertiefung (17) eingeführt ist, sowie Vorsprünge (20), die an einer Mehrzahl von Stellen an einer Innenumfangsfläche des dickwandigen Bereichs (19) peripher hervorstehen und für den Schnappeingriff in die Eingriffsöffnungen (14) dienen, an dem Öffnungsende des zweiten Gehäuseelements (12) ausgebildet sind,
**dadurch gekennzeichnet, dass** der innere Wandteil (15) mit dem dickwandigen Bereich (19) in Kontakt steht.

2. Wasserdichtes Gehäuse eines elektronischen Geräts nach Anspruch 1,
**dadurch gekennzeichnet, dass** das zweite Gehäuseelement (12) derart ausgebildet ist, dass eine Distanz zwischen dem Vorsprung (20) und einem vorderen Ende des dickwandigen Bereichs (19) in der Axialrichtung derart gewählt ist, dass das Einführen des dickwandigen Bereichs (19) in die ringförmige Vertiefung (17) in einem Zustand beginnt, in dem eine Neigungsfläche (20a) des Vorsprungs (20) an einem vorderen Ende des inneren Wandteils (15) anliegt, wenn das zweite Gehäuseelement (12) mit dem ersten Gehäuseelement (11) verbunden wird.

## Revendications

1. Boîtier étanche à l'eau pour dispositif électronique, dans lequel un espace intérieur (S) pour loger le dispositif électronique est défini en assemblant l'un à l'autre un premier élément de boîtier (11) et un second élément de boîtier (12) composés d'un produit en résine moulée ;
dans lequel une partie de paroi intérieure cylindrique (15) ayant des trous de fixation (14) en plusieurs endroits sur sa périphérie, une partie de paroi extérieure cylindrique (16) entourant la partie de paroi intérieure (15), un évidement de forme annulaire (17) qui est formé entre la partie de paroi intérieure (15) et la partie de paroi extérieure (16), dans lequel une partie du second élément de boîtier (12) est insérée dans une direction d'insertion suivant une direction axiale du second élément de boîtier (12), et dans lequel un adhésif (13) remplit au moins une partie de fond intérieure, sont prévus à l'extrémité d'ouverture du premier élément de boîtier (11), et une position d'extrémité arrière du trou de fixation (14) le long d'une direction axiale vue dans la direction d'insertion est de niveau avec ou avant la position d'une extrémité avant de la partie de paroi extérieure (16) ; et dans lequel
une partie cylindrique à paroi mince (18) qui est montée autour de la partie de paroi intérieure (15) à insérer dans l'évidement de forme annulaire (17), une partie cylindrique à paroi épaisse (19) ayant une épaisseur sensiblement égale à la dimension de largeur de l'évidement de forme annulaire (17), qui est formée en continu à l'extrémité arrière de la partie cylindrique à paroi mince (18), et dont la partie partielle est insérée dans l'évidement de forme annulaire (17), et des protubérances (20), qui font saillie depuis plusieurs endroits sur la périphérie d'une surface périphérique intérieure de la partie à paroi épaisse (19) pour être logées par pression dans les trous de fixation (14), sont formées au niveau de l'extrémité d'ouverture du second élément de boîtier (12),
**caractérisé en ce que** ladite partie de paroi intérieure (15) est en contact avec ladite partie à paroi épaisse (19).

2. Boîtier étanche à l'eau pour dispositif électronique selon la revendication 1, **caractérisé en ce que** le second élément de boîtier (12) est conçu de telle manière que la distance entre la protubérance (20) et une extrémité avant de la partie à paroi épaisse (19) le long d'une direction axiale est prédéfinie, de sorte que l'insertion de la partie à paroi épaisse (19) dans l'évidement de forme annulaire (17) commence dans un état dans lequel une face inclinée (20a) de la protubérance (20) bute contre une extrémité avant de la partie de paroi intérieure (15), quand le second élément de boîtier (12) est assemblé au premier élément de boîtier (11).
